(19) Europäisches Patentamt
European Patent Office
Office européen des brevets

(11) **EP 4 668 318 A1**

(12) **EUROPEAN PATENT APPLICATION**
published in accordance with Art. 153(4) EPC

(43) Date of publication:
**24.12.2025 Bulletin 2025/52**

(21) Application number: 24756939.5

(22) Date of filing: **15.02.2024**

(51) International Patent Classification (IPC):
*H01L 21/304* $^{(2006.01)}$    *C11D 7/06* $^{(2006.01)}$
*C11D 7/18* $^{(2006.01)}$    *C11D 7/32* $^{(2006.01)}$
*C11D 7/36* $^{(2006.01)}$

(52) Cooperative Patent Classification (CPC):
**C11D 3/39; C11D 7/06; C11D 7/32; C11D 7/36;
H01L 21/304**

(86) International application number:
**PCT/JP2024/005151**

(87) International publication number:
**WO 2024/172099 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.02.2023 JP 2023022649**

(71) Applicant: **MITSUBISHI GAS CHEMICAL
COMPANY, INC.**
**Chiyoda-ku**
**Tokyo 100-8324 (JP)**

(72) Inventors:
• **YAMASHITA, Kohji**
  **Tokyo 125-8601 (JP)**
• **HORIE, Hiroaki**
  **Tokyo 125-8601 (JP)**

(74) Representative: **Müller-Boré & Partner
Patentanwälte PartG mbB
Friedenheimer Brücke 21
80639 München (DE)**

(54) **SEMICONDUCTOR SUBSTRATE CLEANING COMPOSITION AND METHOD FOR CLEANING USING SAME**

(57)    The present invention provides a semiconductor substrate cleaning composition comprising hydrogen peroxide, an alkaline compound, phosphoric acid and/or a salt thereof, boric acid and/or a salt thereof, aminopolymethylene phosphonic acid, and water, wherein the alkaline compound comprises at least one selected from the group consisting of quaternary ammonium hydroxide and potassium hydroxide.

EP 4 668 318 A1

**Description**

Technical Field

The present invention relates to a semiconductor substrate cleaning composition and a cleaning method using the same.

Background Art

In production of a semiconductor substrate with highly integrated semiconductor elements, a conductive thin film such as a metal film that serves as a conductive wiring material, an interlayer insulating film for insulating between the conductive thin films, a hard mask, etc. are usually formed on a substrate such as a silicon wafer, and thereafter, a photoresist is uniformly applied onto the surface thereof to form a photosensitive layer, which is then subjected to selective exposure and development processing to create a desired resist pattern. Subsequently, using this resist pattern as a mask, a dry etching treatment is performed on the substrate on which the interlayer insulating film, the hard mask, etc. are layered, thereby forming a desired pattern on the substrate. After that, the photoresist pattern and residues generated by the dry etching treatment (hereinafter referred to as "dry etching residues") are removed by ashing with oxygen plasma, a cleaning solution, etc. Thus, a series of steps is generally carried out.

When dry etching is performed until a wiring material is reached, there is a case where the wiring material may be exposed to the dry etching gas and may change in quality, which may affect the electrical characteristics. Accordingly, it is conceived to establish a step, in which an etching stop layer (which is also referred to as an "etching stopper layer") is provided on the wiring material, a via is formed until the etching stop layer is reached by dry etching, and then the etching stop layer at the bottom of the via is removed by a method that little affects the wiring material, so that the wiring material is exposed, and then, the hard mask is removed. For this reason, it is desired to develop a chemical solution that removes the hard mask and dry etching residues, while suppressing the damage to copper or a copper alloy, cobalt or a cobalt alloy, and the etching stop layer.

In recent years, since the current density of metal wiring has increased because of the progress of miniaturization of design rules, it has been strongly desired to take measures against electromigration, in which holes are formed in the metal wiring due to the movement of atoms that constitute the metal wiring when a current flows through the metal wiring material. As such measures, there are a method of forming a layer of cobalt or a cobalt alloy as a cap metal around the copper wiring, and a method of using cobalt or a cobalt alloy as a metal wiring material. Therefore, in the formation of semiconductor elements on a substrate such as a silicon wafer, a method of removing a hard mask in the presence of copper or a copper alloy, and cobalt or a cobalt alloy, has been proposed.

Patent Literatures 2 and 3 propose a method of removing a hard mask consisting of titanium nitride using an alkaline cleaning solution containing hydrogen peroxide.

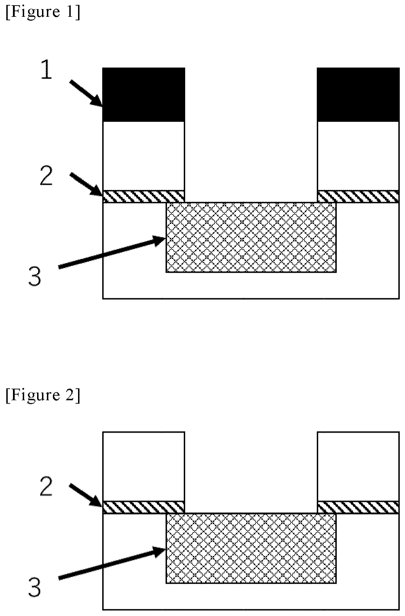

When aluminum nitride is used in an etching stop layer, it has been problematic in that if a semiconductor substrate as shown in Figure 1 is cleaned using a conventional alkaline semiconductor substrate cleaning composition in order to remove a hard mask consisting of titanium nitride, the etching rate of aluminum nitride is high and the etching stop layer 2 containing aluminum nitride is scraped off.

Patent Literature 1 discloses a cleaning composition that helps the removal of residues after etching in production of a semiconductor, and discloses that the composition comprises a tetraalkylammonium hydroxide base or a quaternary trialkylalkanolamine base, a corrosion inhibitor, and a combination of at least two or more types of polybasic acids or salts thereof, and that at least one type of the polybasic acid, or the salt thereof, contains phosphorus.

In addition, in Patent Literature 1, the etching rate of aluminum nitride is suppressed by phosphoric acid, and further, the damage of metal wiring is reduced by using 5-methyl-benzotriazole. However, azole-based anticorrosive agents such as 5-methyl-benzotriazole have a high anticorrosive effect on metals, but they may remain on the surface of the metal after cleaning, or may worsen the removability of metal residues. Moreover, particularly effective anticorrosive agents such as 5-methyl-benzotriazole are generally expensive. Thus, azole-based anticorrosive agents such as 5-methyl-benzotriazole are not used, or even if such azole-based anticorrosive agents are used, they are desirably used in small amounts.

As a composition that does not use an azole-based anticorrosive agent, a cleaning composition comprising hydrogen peroxide, potassium hydroxide, quaternary ammonium hydroxide, and aminopolymethylene phosphonic acid has been proposed in Patent Literatures 2 and 3. However, there has been a problem that it is difficult to suppress both the etching rate of aluminum nitride and that of metal wiring.

Citation List

Patent Literature

Patent Literature 1: WO2018/098139
Patent Literature 2: WO2022/071069
Patent Literature 3: WO2014/087925

Summary of Invention

Technical Problem

In view of the problems in the above-mentioned conventional techniques, it is an object of the present invention to provide: a semiconductor substrate cleaning composition capable of removing a hard mask layer, while suppressing the etching rate of aluminum nitride contained in the etching stop layer, and also while suppressing the damage of copper and/or cobalt contained in the metal wiring, without using an azole-based anticorrosive agent; and a cleaning method using the same.

Solution to Problem

The present inventors have conducted intensive studies directed towards achieving the above-described object, and as a result, the present inventors have found that a semiconductor substrate cleaning composition capable of removing a hard mask layer, while suppressing the etching rate of aluminum nitride contained in the etching stop layer, and also while suppressing the damage of copper and/or cobalt contained in the metal wiring, without using an azole-based anticorrosive agent, can be obtained by using phosphoric acid and boric acid in combination, thereby completing the present invention.

Specifically, the present invention includes the following aspects.

< 1 > A semiconductor substrate cleaning composition comprising hydrogen peroxide, an alkaline compound, phosphoric acid and/or a salt thereof, boric acid and/or a salt thereof, aminopolymethylene phosphonic acid, and water, wherein the alkaline compound comprises at least one selected from the group consisting of quaternary ammonium hydroxide and potassium hydroxide.

< 2 > The semiconductor substrate cleaning composition according to the above < 1 >, wherein the salt of the phosphoric acid is at least one selected from the group consisting of quaternary ammonium phosphate salts and potassium phosphate salts, and the salt of the boric acid is at least one selected from the group consisting of quaternary ammonium borate salts and potassium borate salts.

< 3 > The semiconductor substrate cleaning composition according to the above < 1 > or < 2 >, wherein the content of the phosphoric acid and/or a salt thereof in the semiconductor substrate cleaning composition is 0.05% to 2% by mass in terms of phosphoric acid, and the content of the boric acid and/or a salt thereof in the semiconductor substrate cleaning composition is 0.1% to 4% by mass in terms of boric acid.

< 4 > The semiconductor substrate cleaning composition according to any one of the above < 1 > to < 3 >, wherein the content of the hydrogen peroxide in the semiconductor substrate cleaning composition is 10% to 30% by mass.

< 5 > The semiconductor substrate cleaning composition according to any one of the above < 1 > to < 4 >, in which the content of the aminopolymethylene phosphonic acid in the semiconductor substrate cleaning composition is 0.00005% to 0.01% by mass.

< 6 > The semiconductor substrate cleaning composition according to any one of the above < 1 > to < 5 >, wherein the content of the quaternary ammonium hydroxide in the semiconductor substrate cleaning composition is 0.005% to 10% by mass.

< 7 > The semiconductor substrate cleaning composition according to any one of the above < 1 > to < 6 >, wherein the content of the potassium hydroxide in the semiconductor substrate cleaning composition is 0.005% to 5% by mass.

< 8 > The semiconductor substrate cleaning composition according to any one of the above < 1 > to < 7 >, wherein the pH of the semiconductor substrate cleaning composition is pH 7 to 12.

< 9 > The semiconductor substrate cleaning composition according to any one of the above < 1 > to < 8 >, wherein the quaternary ammonium hydroxide is at least one selected from the group consisting of tetramethylammonium hydroxide, tetraethylammonium hydroxide, tetrapropylammonium hydroxide, tetrabutylammonium hydroxide, and benzyltrimethylammonium hydroxide.

< 10 > The semiconductor substrate cleaning composition according to any one of the above < 1 > to < 9 >, wherein the aminopolymethylene phosphonic acid is at least one selected from the group consisting of aminotri(methylenephosphonic acid), ethylenediaminetetra(methylenephosphonic acid), diethylenetriaminepenta(methylenephosphonic acid), and 1,2-propylenediaminetetra(methylenephosphonic acid).

< 11 > The semiconductor substrate cleaning composition according to any one of the above < 1 > to < 10 >, which further comprises at least one hydrogen peroxide stabilizer selected from the group consisting of oxalic acid, diethylenetriaminepentaacetic acid, hydroxyethyliminodiacetic acid, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

< 12 > The semiconductor substrate cleaning composition according to the above < 11 >, wherein the content of the hydrogen peroxide stabilizer in the semiconductor substrate cleaning composition is 0.0001% to 5% by mass.

< 13 > The semiconductor substrate cleaning composition according to any one of the above < 1 > to < 12 >, which does not substantially comprise either ammonia or ammonium ions ($NH^{4+}$).

< 14 > A method for cleaning a semiconductor substrate, which comprises using the semiconductor substrate cleaning composition according to any one of the above < 1 > to < 13 > for a semiconductor substrate having an etching stop layer containing aluminum nitride, and a hard mask layer, on metal wiring containing copper and/or cobalt, so as to remove the hard mask layer.

< 15 > The method for cleaning a semiconductor substrate according to the above < 14 >, wherein the hard mask layer contains at least one selected from the group consisting of titanium and titanium nitride.

< 16 > A method for producing a semiconductor substrate, which comprises a step of using the semiconductor substrate cleaning composition according to any one of the above < 1 > to < 13 > for a semiconductor substrate having an etching stop layer containing aluminum nitride, and a hard mask layer, on metal wiring containing copper and/or cobalt, so as to remove the hard mask layer.

Advantageous Effects of Invention

By using the semiconductor substrate cleaning composition and the cleaning method of the present invention, the hard mask layer 1 can be removed from the semiconductor substrate shown in Figure 1, while suppressing the etching rate of aluminum nitride contained in the etching stop layer 2 (suppressing damage), and also while suppressing the damage of copper and/or cobalt contained in the metal wiring 3.

Brief Description of Drawings

[Figure 1] Figure 1 is a schematic view of the cross section of a semiconductor substrate, before cleaning the semiconductor substrate using a semiconductor substrate cleaning composition.
[Figure 2] Figure 2 is a schematic view of the cross section of a semiconductor substrate, after cleaning the semiconductor substrate using a semiconductor substrate cleaning composition.

Description of Embodiments

Hereinafter, the present invention will be described in detail by showing embodiments, examples, etc. However, the present invention is not limited to the following embodiments, examples, etc., and the present invention can be modified and carried out as desired, without deviating from the gist of the present invention.

[Semiconductor substrate cleaning composition]

The semiconductor substrate cleaning composition of the present invention comprises hydrogen peroxide, an alkaline compound, phosphoric acid and/or a salt thereof, boric acid and/or a salt thereof, aminopolymethylene phosphonic acid, and water. Hereafter, individual components will be described in detail.

< Hydrogen peroxide >

Hydrogen peroxide is usually mixed with other components as an aqueous solution having a moderate concentration. The concentration of hydrogen peroxide in the aqueous hydrogen peroxide solution used in the production of the semiconductor substrate cleaning composition of the present invention is not particularly limited, and for example, it is preferably 10% to 90% by mass. It is more preferably 30% to 60% by mass that is in accordance with industrial standards.

Moreover, hydrogen peroxide may contain a stabilizer used during the production thereof. The method for producing hydrogen peroxide is not limited, and for example, hydrogen peroxide, etc. produced by an anthraquinone method is preferably used. Furthermore, hydrogen peroxide may also be purified by passing it into an ion exchange resin or other methods.

From the viewpoint of cleaning properties, the content of hydrogen peroxide in the semiconductor substrate cleaning composition is preferably 10% to 30% by mass, and more preferably 10% to 20% by mass.

< Alkaline compound >

The alkaline compound comprises at least one selected from the group consisting of quaternary ammonium hydroxide and potassium hydroxide. The alkaline compound can effectively remove hard masks and dry etching residues, and can suppress the damage of low dielectric constant interlayer insulating films and metal wiring. Quaternary ammonium hydroxide and potassium hydroxide can be used alone or in combination of two or more types.

In particular, it is preferable that the alkaline compound comprises both quaternary ammonium hydroxide and potassium hydroxide.

The quaternary ammonium hydroxide is not particularly limited, and it is preferably at least one selected from the group consisting of tetramethylammonium hydroxide, tetraethylammonium hydroxide, tetrapropylammonium hydroxide, tetrabutylammonium hydroxide, and benzyltrimethylammonium hydroxide. From the viewpoint of economy and the ease availability of raw materials, the quaternary ammonium hydroxide is more preferably at least one selected from the group consisting of tetramethylammonium hydroxide, tetraethylammonium hydroxide, and benzyltrimethylammonium hydroxide, and tetramethylammonium hydroxide is further preferable.

The content of the quaternary ammonium hydroxide in the semiconductor substrate cleaning composition is preferably 0.005% to 10% by mass, more preferably 0.5% to 7% by mass, and further preferably 1% to 6% by mass.

The content of the potassium hydroxide in the semiconductor substrate cleaning composition is preferably 0.005% to 5% by mass, more preferably 0.01% to 5% by mass, and further preferably 0.1% to 1% by mass.

If the content of the alkaline compound is within the above-described range, in particular, the etching rate of titanium and titanium nitride becomes favorable, which is preferable.

< Phosphoric acid and/or a salt thereof, and boric acid and/or a salt thereof >

In the present invention, as shown in Figure 2, since an increase in the etching rate of cobalt contained in the metal wiring 3 can be suppressed, while suppressing the etching rate of aluminum nitride contained in the etching stop layer 2 (suppressing damage), by using phosphoric acid and boric acid in combination, the damage of the metal wiring 3 can be suppressed. In the case of using phosphoric acid alone, the etching rate of cobalt is increased. However, by adding boric acid, an increase in the etching rate of cobalt can be suppressed.

In the present invention, phosphoric acid and boric acid are used in combination, and it is believed that most of these compounds exist as salts in the semiconductor substrate cleaning composition.

In the present invention, the salt of the phosphoric acid is preferably at least one selected from the group consisting of quaternary ammonium phosphate salts and potassium phosphate salts.

On the other hand, the salt of the boric acid is preferably at least one selected from the group consisting of quaternary ammonium borate salts and potassium borate salts.

The content of phosphoric acid and/or a salt thereof in the semiconductor substrate cleaning composition is preferably 0.05% to 2% by mass, more preferably 0.1% to 1.5% by mass, and particularly preferably 0.25% to 1% by mass, in terms of phosphoric acid.

The content of boric acid and/or a salt thereof in the semiconductor substrate cleaning composition is preferably 0.1% to 4% by mass, more preferably 0.2% to 3% by mass, and particularly preferably 0.5% to 2% by mass, in terms of boric acid.

< Aminopolymethylene phosphonic acid >

Since the semiconductor substrate cleaning composition of the present invention comprises aminopolymethylene phosphonic acid, it forms a chelate when copper ions are present, which preferably improves the stability of hydrogen peroxide.

The aminopolymethylene phosphonic acid is preferably at least one selected from the group consisting of aminotri(methylenephosphonic acid), ethylenediaminetetra(methylenephosphonic acid), diethylenetriaminepenta(methylenephosphonic acid), and 1,2-propylenediaminetetra(methylenephosphonic acid).

The content of the aminopolymethylene phosphonic acid in the semiconductor substrate cleaning composition is preferably 0.00005% to 0.01% by mass, more preferably 0.0005% to 0.005% by mass, and further preferably 0.001% to 0.004% by mass.

If the content of the aminopolymethylene phosphonic acid is within the above-described range, costs can be reduced, while maintaining the stability of hydrogen peroxide.

< Water >

Water is not particularly limited, and it is preferably water, from which metal ions, organic impurities, particles, etc. have been removed by distillation, an ion exchange treatment, a filter treatment, various types of adsorption treatments, etc. It is more preferably pure water, and particularly preferably ultrapure water.

The content of the water is the remainder of the semiconductor substrate cleaning composition of the present invention after removing hydrogen peroxide, alkaline compound, phosphoric acid and/or a salt thereof, boric acid and/or a salt thereof, aminopolymethylene phosphonic acid, and other components. The water content is preferably 50% by mass or more, more preferably 72% to 89.9385% by mass, further preferably 73% to 89.798% by mass, still further preferably 73% to 87% by mass, and particularly preferably 75% to 85% by mass, in the semiconductor substrate cleaning composition. If the water content is within the above range, the effects of the present invention can be exhibited, and further, it is economical.

< Hydrogen peroxide stabilizer >

The semiconductor substrate cleaning composition of the present invention preferably comprises a hydrogen peroxide stabilizer.

The hydrogen peroxide stabilizer preferably contains at least one selected from the group consisting of oxalic acid, diethylenetriaminepentaacetic acid, hydroxyethyliminodiacetic acid, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

In a preferred embodiment of the present invention, since the present semiconductor substrate cleaning composition comprises the above-described hydrogen peroxide stabilizer, the stability of hydrogen peroxide is high even in the coexistence of multiple metals including cobalt, and the hydrogen peroxide can be cleaned for a long time or can be used repeatedly. In a preferred embodiment of the present invention, since the present semiconductor substrate cleaning composition comprises the above-described hydrogen peroxide stabilizer, the stability of hydrogen peroxide is high, particularly in the coexistence of copper and cobalt, and the hydrogen peroxide can be cleaned for a long time or can be used repeatedly.

In the cleaning of a semiconductor substrate using a semiconductor substrate cleaning composition, when multiple metals including cobalt are present, and in particular when both copper and cobalt are present, in particular, decomposition of hydrogen peroxide easily occurs.

The reason why the preferred embodiment of the present invention enhances the stability of hydrogen peroxide in the coexistence of particularly copper and cobalt, as described above, is unknown. However, the compounds exemplified herein are considered to express strong chelating ability on either copper ions or cobalt ions, or on both copper ions and cobalt ions, even in the presence of two types of metals and in an alkaline solution, due to their structures, and especially, the balance between amino groups and carboxy groups. In addition, copper ions and cobalt ions have a certain hydrogen peroxide decomposition ability even when they are used alone, but as mentioned above, it has been problematic in that the simultaneous presence of copper ions and cobalt ions increases the decomposition rate. With regard to this mechanism, it is considered that, in addition to the catalytic effects of copper ions and cobalt ions, a Fenton-like reaction progresses due to the presence of copper ions, and hydroxyl radicals are generated, which are associated with the mechanism. In a preferred embodiment of the present invention, it is considered that since the hydrogen peroxide stabilizer has an ability to capture hydroxyl radicals, as well as chelating ability, it further enhances the stability of hydrogen peroxide.

Among the hydrogen peroxide stabilizers, from the viewpoint of suppressing corrosion of metals, etc. constituting the semiconductor substrate, at least one selected from the group consisting of oxalic acid, diethylenetriaminepentaacetic acid, hydroxyethyliminodiacetic acid, triethylenetetraminehexaacetic acid, trans-1,2-cyclohexanediaminetetraacetic acid, 8-quinolinol, hydroxyethylethylenediaminetriacetic acid, 5-phenyl-1H-tetrazole,N,N-di(2-hydroxyethyl)glycine, and benzotriazole is preferable; from the viewpoint of further improving the stability of hydrogen peroxide while suppressing metal corrosion, at least one selected from the group consisting of diethylenetriaminepentaacetic acid, hydroxyethyliminodiacetic acid, triethylenetetraminehexaacetic acid, hydroxyethylethylenediaminetriacetic acid, and trans-1,2-cyclohexanediaminetetraacetic acid is more preferable; at least one selected from the group consisting of diethylenetriaminepentaacetic acid and trans-1,2-cyclohexanediaminetetraacetic acid is further preferable; and trans-1,2-cyclohexanediaminetetraacetic acid is particularly preferable.

Semiconductor substrates comprise metal parts such as metal wiring. It is considered that, in particular, the hydrogen peroxide stabilizer shown herein has the unique property of capturing metal ions in a solution and not contributing to ionization of the metal, and that the hydrogen peroxide stabilizer stabilizes hydrogen peroxide and enhances cleaning properties, without corroding metal wiring and the like. Furthermore, it is also considered that the present hydrogen peroxide stabilizer has an ability to capture hydroxyl radicals.

The hydrogen peroxide stabilizer includes the above-described compounds. Hydrates, salts, derivatives, etc. that generate these compounds in cleaning compositions can also be used. For example, trans-1,2-cyclohexanediaminetetraacetic acid is preferably used in the form of a monohydrate from the viewpoints of availability and the ease of blending.

In a preferred embodiment of the present invention, the content of the hydrogen peroxide stabilizer in the semiconductor substrate cleaning composition is preferably 0.0001% to 5% by mass, and more preferably 0.001% to 1% by mass.

By setting the content of the hydrogen peroxide stabilizer within the above-described range, in the semiconductor substrate cleaning composition of the present invention, hydrogen peroxide has high stability in the coexistence of multiple metals including cobalt, in particular, in the coexistence of copper and cobalt, and the hydrogen peroxide can be cleaned for a long of time or can be used repeatedly. Moreover, it also becomes possible to suppress corrosion of the metals, etc. constituting the semiconductor substrate.

< Other components >

In addition to the above-described components, the semiconductor substrate cleaning composition of the present invention may comprise other components within a range that does not impair the purpose of the present invention. For example, a surfactant, a defoaming agent, etc. may be added.

In the semiconductor substrate cleaning composition of the present invention, since ammonia and ammonium ions ($NH^{4+}$) have the action of increasing the corrosion of copper and cobalt, the present semiconductor substrate cleaning composition preferably does not substantially comprise both of them. Herein, the expression "not substantially comprise" means that the present semiconductor substrate cleaning composition does not comprise them, or comprises them within a range that does not impair the effects of the present invention. Specifically, the total content of ammonia and ammonium ions ($NH^{4+}$) in the semiconductor substrate cleaning composition is preferably less than 0.01% by mass, more preferably less than 10 ppm by mass, and further preferably, the semiconductor substrate cleaning composition comprises neither ammonia nor ammonium ions ($NH^{4+}$).

< Properties, etc. of semiconductor substrate cleaning composition >

The pH of the semiconductor substrate cleaning composition of the present invention is preferably pH 7 to 12, more preferably pH 7.5 to 11, further preferably pH 8 to 10, and particularly preferably pH 8 to 9. By setting the pH value within the above-described range, the stability of hydrogen peroxide can be maintained at a high level, and cleaning properties can also be enhanced. The pH value can be measured by the method described in the Examples.

(Semiconductor substrate cleaning composition for cleaning semiconductor substrate, comprising cobalt and/or copper)

The semiconductor substrate cleaning composition of a preferred embodiment of the present invention is preferably for use in cleaning a semiconductor substrate comprising cobalt and/or copper. Furthermore, the semiconductor substrate cleaning composition of a preferred embodiment of the present invention is more preferably for use in cleaning a semiconductor substrate comprising both cobalt and copper. Even when the semiconductor substrate cleaning composition of a preferred embodiment of the present invention is used to clean a semiconductor substrate comprising both cobalt and copper, the semiconductor substrate cleaning composition has high hydrogen peroxide stability. It is to be noted that such cobalt and copper are used as metal wiring, etc. of the semiconductor substrate.

In the semiconductor substrate, cobalt and copper may be used as these metals alone (pure metals) or as an alloy.

(Semiconductor substrate cleaning composition for cleaning semiconductor substrate, having hard mask containing titanium and titanium nitride)

The semiconductor substrate cleaning composition of the present invention is preferably for use in cleaning a semiconductor substrate having a hard mask containing at least one selected from the group consisting of titanium and titanium nitride, and is more preferably for use in cleaning a semiconductor substrate having a hard mask containing titanium nitride. Moreover, the semiconductor substrate cleaning composition of the present invention is preferably for use in cleaning a semiconductor substrate having a hard mask consisting of at least one selected from the group consisting of titanium and titanium nitride, and is more preferably for use in cleaning a semiconductor substrate having a hard mask consisting of titanium nitride.

(Semiconductor substrate cleaning composition for cleaning semiconductor substrate, having etching stop layer containing aluminum nitride)

The semiconductor substrate cleaning composition of the present invention is preferably for use in cleaning a semiconductor substrate having an etching stop layer containing aluminum nitride.

[Cleaning method]

The cleaning method of the present invention is a cleaning method, which comprises using the above-described semiconductor substrate cleaning composition for a semiconductor substrate having an etching stop layer containing aluminum nitride, and a hard mask layer, on metal wiring containing copper and/or cobalt, so as to remove the hard mask layer.

In the present invention, the hard mask layer preferably contains at least one selected from the group consisting of titanium and titanium nitride, and more preferably contains titanium nitride. Moreover, in the present invention, the hard mask layer preferably consists of at least one selected from the group consisting of titanium and titanium nitride, and more preferably consists of titanium nitride.

Even if the cleaning method of a preferred embodiment of the present invention is carried out on a semiconductor substrate having an etching stop layer containing aluminum nitride, it can efficiently remove dry etching residues and hard masks from the semiconductor substrate, while suppressing damage to the etching stop layer.

In the cleaning method of the present invention, the method of allowing the semiconductor substrate cleaning composition of the present invention to come into contact with a semiconductor substrate is not particularly limited. For example, a method of allowing the semiconductor substrate cleaning composition of the present invention to come into contact with a semiconductor substrate by dropping (a single-wafer spin treatment) or spraying (a spraying treatment), etc., or a method of immersing a semiconductor substrate in the semiconductor substrate cleaning composition of the present invention, etc. can be adopted. In the present invention, any method may be adopted.

In addition, the temperature applied during cleaning in the cleaning method of the present invention is not particularly limited, and it is preferably 20°C to 80°C, and more preferably 25°C to 70°C. Moreover, ultrasonic waves may also be used during cleaning.

The cleaning time in the cleaning method of the present invention is not particularly limited, and it is preferably 0.3 to 20 minutes, and more preferably 0.5 to 10 minutes.

The pH of the cleaning solution in the cleaning method of the present invention is preferably pH 7 to 12, more preferably pH 7.5 to 11, further preferably pH 8 to 10, and particularly preferably pH 8 to 9.

In the cleaning method of the present invention, it is preferable to further rinse the semiconductor substrate with a rinse solution containing water, alcohol, etc., after cleaning.

[Method for producing a semiconductor substrate]

The method for producing a semiconductor substrate of the present invention comprises a step of using the above-described semiconductor substrate cleaning composition for a semiconductor substrate having an etching stop layer containing aluminum nitride, and a hard mask layer, on metal wiring containing copper and/or cobalt, so as to remove the hard mask layer. A specific method for producing a semiconductor substrate is shown below.

First, an etching stop layer, a barrier insulating film, a low dielectric constant interlayer insulating film, a hard mask layer and a photoresist are laminated on a substrate, such as silicon, having a barrier metal, metal wiring, a low dielectric constant interlayer insulating film and, as necessary, a cap metal, and thereafter, selective exposure and development treatments are performed on the photoresist to form a photoresist pattern. Next, this photoresist pattern is transferred onto the hard mask layer by dry etching. Thereafter, the photoresist pattern is removed, and using the hard mask layer as an etching mask, a dry etching treatment is performed on the low dielectric constant interlayer insulating film and the barrier insulating film. Subsequently, the above-described step, namely, a step of using the semiconductor substrate cleaning composition to remove the hard mask layer from the semiconductor substrate is performed, so as to obtain a semiconductor substrate having a desired metal wiring pattern.

Here, silicon, amorphous silicon, polysilicon, glass, or the like is used as a substrate material. Tantalum, tantalum nitride, ruthenium, manganese, magnesium, cobalt, an oxide thereof, or the like are used as barrier metal. As metal wiring, copper or a copper alloy, copper or a copper alloy on which cobalt or a cobalt alloy is formed as a cap metal, cobalt or a cobalt alloy, or the like is used. As a low dielectric constant interlayer insulating film, polysiloxane-based OCD (product name, manufactured by TOKYO OHKA KOGYO CO., LTD.), carbon-doped silicon oxide (SiOC)-based Black Diamond (product name, manufactured by Applied Materials), or the like is used.

Aluminum nitride is used as an etching stop layer. Silicon nitride, silicon carbide, silicon carbonitride, or the like is used as a barrier insulating film. Titanium, titanium nitride or the like is used as a hard mask layer.

According to the method for producing a semiconductor substrate of the present invention, since the present production method has a step of removing unnecessary components using the above-described semiconductor substrate cleaning composition, a semiconductor substrate having high accuracy and high quality can be obtained with a good yield.

Examples

Hereinafter, the present invention will be more specifically described in the following examples and comparative example. However, these examples are not intended to limit the scope of the present invention.

< Analysis method and evaluation method >

pH

The pH of the semiconductor substrate cleaning composition was measured by a glass electrode method (F-55S benchtop pH meter, manufactured by HORIBA; Standard ToupH electrode 9165S-10D, manufactured by HORIBA; temperature: 25°C).

Evaluation of etching rate

[Titanium nitride]

A 2-cm-square test piece was cut from a silicon wafer (manufactured by Advantec), on which a film of titanium nitride with a thickness of 1000 angstroms had been formed by PVD (physical vapor deposition method), and the film thickness thereof was then measured by fluorescent X-ray analysis (EA1400, manufactured by Hitachi). Thereafter, the test piece was immersed in a semiconductor substrate cleaning composition at 50°C for 2 minutes and was then rinsed with ultrapure water at room temperature, and the film thickness thereof was measured again by fluorescent X-ray analysis to measure the amount of thickness reduced per unit time.

[Aluminum nitride]

A 1-cm-square test piece was cut from a silicon wafer (manufactured by Philtech), in which a film of aluminum nitride with a thickness of 250 angstrom had been formed on a thermal oxide film with a thickness of 1000 angstrom by ALD (atomic layer deposition method), and the film thickness thereof was then measured using a spectroscopic ellipsometer (UVISEL Plus, manufactured by HORIBA). Thereafter, the test piece was immersed in a semiconductor substrate cleaning composition at 50°C for 15 minutes and was then rinsed with ultrapure water at room temperature, and the film thickness was measured again using the spectroscopic ellipsometer to measure the amount of thickness reduced per unit time.

[Copper and cobalt]

A 2-cm-square test piece was cut from a silicon wafer (manufactured by Philtech), in which a film of electroplated copper with a thickness of 10000 angstrom had been formed on a PVD seed layer with a thickness of 1000 angstrom, followed by an annealing treatment, or from a silicon wafer (manufactured by Advantec), on which a film of cobalt with a thickness of 2000 angstrom had been formed by PVD, and the test piece was then immersed in a semiconductor substrate cleaning composition at 50°C for 5 minutes. After the immersion, the semiconductor substrate cleaning composition was diluted 10 to 20 times with 1% by mass of nitric acid, and the metal concentration was then measured using an inductively coupled plasma optical emission analyzer (SPECTROGREEN, manufactured by Hitachi High-Tech Science Corporation). The copper or cobalt concentration (metal concentration) before the dilution was calculated, and the obtained value was then substituted into the following equation to calculate the etching rate (ER) of copper or cobalt. It is to be noted that the density of copper was set to be 8.96 $g/cm^3$ and the density of cobalt was set to be 8.90 $g/cm^3$ for calculation.

$$ER\,(\text{Å/min}) = \frac{\text{Metal concentration before dilution }(\mu g/kg) \times \text{amount of composition used }(g)}{\text{Density }(g/cm^3) \times \text{area of test piece}(cm^2)}$$

$$\times \frac{1}{10} \times \frac{1}{\text{immersion time }(min)}$$

< Semiconductor substrate cleaning compositions >

(Example 1)

A semiconductor substrate cleaning composition was obtained by mixing hydrogen peroxide, potassium hydroxide (KOH), tetramethylammonium hydroxide (TMAH), ethylenediaminetetra(methylenephosphonic acid) (EDTMP), phosphoric acid, boric acid, and water, to result in the mass ratio shown in Table 1. Using the obtained composition, the evaluation shown in Table 1 was carried out.

(Examples 2 and 3)

A semiconductor substrate cleaning composition was obtained by mixing hydrogen peroxide, potassium hydroxide or tetramethylammonium hydroxide (TMAH), ethylenediaminetetra(methylenephosphonic acid) (EDTMP), phosphoric acid, boric acid, and water, to result in the mass ratio shown in Table 1. Using the obtained composition, the evaluation shown in Table 1 was carried out.

(Examples 4 and 5)

A semiconductor substrate cleaning composition was obtained by mixing hydrogen peroxide, potassium hydroxide (KOH), tetramethylammonium hydroxide (TMAH), propylenediaminetetra(methylenephosphonic acid) (PDTMP), phosphoric acid, boric acid, and water, to result in the mass ratio shown in Table 1. Using the obtained composition, the evaluation shown in Table 1 was carried out.

(Examples 6 and 7)

A semiconductor substrate cleaning composition was obtained by mixing hydrogen peroxide, potassium hydroxide (KOH), tetraethylammonium hydroxide (TEAH) or benzyltrimethylammonium hydroxide (BTMAH), ethylenediaminetetra(methylenephosphonic acid) (EDTMP), phosphoric acid, boric acid, and water, to result in the mass ratio shown in Table 1. Using the obtained composition, the evaluation shown in Table 1 was carried out.

(Comparative Example 1)

A semiconductor substrate cleaning composition was obtained by mixing hydrogen peroxide, potassium hydroxide (KOH), tetramethylammonium hydroxide (TMAH), ethylenediaminetetra(methylenephosphonic acid) (EDTMP), and water, to result in the mass ratio shown in Table 1. Using the obtained composition, the evaluation shown in Table 1 was carried out. As a result, the etching rate of aluminum nitride became a larger value than those in the compositions comprising phosphoric acid and boric acid (Examples 1 to 7).

(Comparative Example 2)

A semiconductor substrate cleaning composition was obtained by mixing hydrogen peroxide, potassium hydroxide (KOH), tetramethylammonium hydroxide (TMAH), ethylenediaminetetra(methylenephosphonic acid) (EDTMP), phosphoric acid, and water, to result in the mass ratio shown in Table 1. Using the obtained composition, the evaluation shown in Table 1 was carried out. As a result, the etching rate of cobalt became a larger value than those in the compositions comprising phosphoric acid and boric acid (Examples 1 to 7) or in the compositions that did not contain phosphoric acid (Comparative Examples 1 and 3).

(Comparative Example 3)

A semiconductor substrate cleaning composition was obtained by mixing hydrogen peroxide, potassium hydroxide (KOH), tetramethylammonium hydroxide (TMAH), ethylenediaminetetra(methylenephosphonic acid) (EDTMP), boric acid, and water, to result in the mass ratio shown in Table 1. Using the obtained composition, the evaluation shown in Table 1 was carried out. As a result, the etching rate of aluminum nitride became a larger value than those in the compositions comprising phosphoric acid and boric acid (Examples 1 to 7).

[Table 1]

| | Component and concentration [wt%] | | | | | | | | | | | pH | ER at 50°C [A/min] | | | |
|---|---|---|---|---|---|---|---|---|---|---|---|---|---|---|---|---|
| | Hydrogen peroxide | KOH | Quaternary ammonium hydroxide | | Aminopolym ethylenophos phonic acid | | Phosphoric acid | Boric acid | Hydrogen peroxide stabilizer | | Water | | TiN | AlN | Cu | Co |
| Example 1 | 16 | 0.15 | TMAH | 2.4 | EDTMP | 0.005 | 0.5 | 1 | | | 79.945 | 8.33 | 194 | 5.4 | <1 | 6.0 |
| Example 2 | 16 | | TMAH | 2.6 | EDTMP | 0.005 | 0.5 | 1 | | | 79.895 | 8.47 | 128 | 12 | <1 | 7.6 |
| Example 3 | 16 | 1.6 | | | EDTMP | 0.005 | 0.5 | 1 | | | 80.895 | 8.37 | 236 | 6.0 | <1 | 7.7 |
| Example 4 | 22 | 0.15 | TMAH | 2.8 | PDTMP | 0.002 | 0.5 | 1 | | | 73.548 | 8.45 | 234 | 9.6 | <1 | 3.4 |
| Example 5 | 10 | 0.15 | TMAH | 2.1 | PDTMP | 0.002 | 0.5 | 1 | | | 86.248 | 8.56 | 101 | 4.9 | <1 | 3.0 |
| Example 6 | 16 | 0.15 | TEAH | 3.9 | EDTMP | 0.002 | 0.5 | 1 | | | 78.448 | 8.61 | 213 | 6.4 | <1 | 2.4 |
| Example 7 | 16 | 0.15 | BTMAH | 4.5 | EDTMP | 0.002 | 0.5 | 1 | | | 77.848 | 8.39 | 182 | 13 | <1 | 2.8 |
| Comp.Ex. 1 | 16 | 0.15 | TMAH | 0.2 | EDTMP | 0.005 | | | | | 83.645 | 8.51 | 215 | 41 | <1 | 4.4 |
| Comp.Ex. 2 | 16 | 0.15 | TMAH | 1 | EDTMP | 0.005 | 0.5 | | | | 82.345 | 8.32 | 224 | 6.6 | <1 | 11 |
| Comp.Ex. 3 | 16 | 0.15 | TMAH | 1.5 | EDTMP | 0.005 | | 1 | | | 81.345 | 8.37 | 196 | 20 | <1 | 4.2 |

TMAH: Tetramethylammonium hydroxide
TEAH: Tetraethylammonium hydroxide
BTMAH: Benzyltrimethylammonium hydroxide
EDTMP: Ethylenediaminetetra(methylenephosphonic acid)
PDTMP: Propylenediaminetetra(methylenephosphonic acid)

(Examples 8 to 12)

A semiconductor substrate cleaning composition was obtained by mixing hydrogen peroxide, potassium hydroxide (KOH), tetramethylammonium hydroxide (TMAH), diethylenetriaminepenta(methylenephosphonic acid) (DTPMP), phosphoric acid, boric acid, diethylenetriaminepentaacetic acid (DTPA), and water, to result in the mass ratio shown in Table 2. Using the obtained composition, the evaluation shown in Table 2 was carried out.

(Example 13)

A semiconductor substrate cleaning composition was obtained by mixing hydrogen peroxide, potassium hydroxide (KOH), tetramethylammonium hydroxide (TMAH), propylenediaminetetra(methylenephosphonic acid) (PDTMP), phosphoric acid, boric acid, trans-1,2-cyclohexanediaminetetraacetic acid monohydrate (CyDTA), and water, to result in the mass ratio shown in Table 2. Using the obtained composition, the evaluation shown in Table 2 was carried out.

(Examples 14 to 17)

A semiconductor substrate cleaning composition was obtained by using triethylenetetraminehexaacetic acid (TTHA), hydroxyethyliminodiacetic acid (HIDA), hydroxyethylethylenediaminetriacetic acid(HEDTA) or oxalic acid, instead of the trans-1,2-cyclohexanediaminetetraacetic acid monohydrate (CyDTA) of Example 13, and then mixing the components to result in the mass ratio shown in Table 2. Using the obtained composition, the evaluation shown in Table 2 was carried out.

(Comparative Example 4)

A semiconductor substrate cleaning composition was obtained by mixing hydrogen peroxide, potassium hydroxide (KOH), tetramethylammonium hydroxide (TMAH), diethylenetriaminepenta(methylenephosphonic acid) (DTPMP), diethylenetriaminepentaacetic acid (DTPA), and water, to result in the mass ratio shown in Table 2. Using the obtained composition, the evaluation shown in Table 2 was carried out. As a result, the etching rate of aluminum nitride became a larger value than those in the compositions comprising phosphoric acid and boric acid (Examples 8 to 12).

(Comparative Example 5)

A semiconductor substrate cleaning composition was obtained by mixing hydrogen peroxide, potassium hydroxide (KOH), tetramethylammonium hydroxide (TMAH), diethylenetriaminepenta(methylenephosphonic acid) (DTPMP), phosphoric acid, diethylenetriaminepentaacetic acid (DTPA), and water, to result in the mass ratio shown in Table 2. Using the obtained composition, the evaluation shown in Table 2 was carried out. As a result, the etching rate of cobalt became a larger value than those in the compositions comprising phosphoric acid and boric acid (Examples 8 to 12) or in the compositions that did not contain phosphoric acid (Comparative Examples 4 and 6).

(Comparative Example 6)

A semiconductor substrate cleaning composition was obtained by mixing hydrogen peroxide, potassium hydroxide (KOH), tetramethylammonium hydroxide (TMAH), diethylenetriaminepenta(methylenephosphonic acid) (DTPMP), boric acid, diethylenetriaminepentaacetic acid(DTPA), and water, to result in the mass ratio shown in Table 2. Using the obtained composition, the evaluation shown in Table 2 was carried out. As a result, the etching rate of aluminum nitride became a larger value than those in the compositions comprising phosphoric acid and boric acid (Examples 8 to 12).

[Table 2]

| | Component and concentration [wt%] | | | | | | | | | | | | pH | ER at 50°C [A/min] | | | |
|---|---|---|---|---|---|---|---|---|---|---|---|---|---|---|---|---|---|
| | Hydrogen peroxide | KOH | Quaternary ammonium hydroxide | | Aminopolym ethylenephos phonic acid | | Phosphoric acid | Boric acid | Hydrogen peroxide stabilizer | | Water | | | TiN | AlN | Cu | Co |
| Example 8 | 16 | 0.15 | TMAH | 2.5 | DTPMP | 0.0005 | 0.5 | 1 | DTPA | 0.03 | 79.8195 | 8.28 | 186 | 5.3 | <1 | 4.3 |
| Example 9 | 16 | 0.15 | TMAH | 5.3 | DTPMP | 0.0005 | 2 | 1 | DTPA | 0.03 | 75.5195 | 8.2 | 193 | 5.1 | <1 | 4.0 |
| Example 10 | 16 | 0.15 | TMAH | 6.8 | DTPMP | 0.0005 | 0.5 | 4 | DTPA | 0.03 | 72.5195 | 8.28 | 147 | 7.8 | <1 | 2.0 |
| Example 11 | 16 | 0.15 | TMAH | 1.7 | DTPMP | 0.0005 | 0.1 | 1 | DTPA | 0.03 | 81.0195 | 8.34 | 174 | 11 | <1 | 3.5 |
| Example 12 | 16 | 0.15 | TMAH | 1.3 | DTPMP | 0.0005 | 0.5 | 0.1 | DTPA | 0.03 | 81.9195 | 8.32 | 200 | 6.8 | <1 | 5.0 |
| Example 13 | 16 | 0.15 | TMAH | 2.5 | PDTMP | 0.001 | 0.5 | 1 | CyDTA | 0.005 | 79.844 | 8.65 | 176 | 12 | 1.3 | 4.9 |
| Example 14 | 16 | 0.15 | TMAH | 2.5 | PDTMP | 0.001 | 0.5 | 1 | TTHA | 0.03 | 79.819 | 8.61 | 171 | 12 | <1 | 5.3 |
| Example 15 | 16 | 0.15 | TMAH | 2.5 | PDTMP | 0.001 | 0.5 | 1 | HIDA | 0.15 | 79.699 | 8.42 | 165 | 5.6 | <1 | 3.8 |
| Example 16 | 16 | 0.15 | TMAH | 2.5 | PDTMP | 0.001 | 0.5 | 1 | HEDTA | 0.15 | 79.699 | 8.48 | 163 | 7.0 | <1 | 3.0 |
| Example 17 | 16 | 0.15 | TMAH | 2.6 | PDTMP | 0.001 | 0.5 | 1 | Oxalic acid | 0.1 | 79.649 | 8.58 | 162 | 8.0 | <1 | 2.8 |
| Comp.Ex. 4 | 16 | 0.15 | TMAH | 0.2 | DTPMP | 0.0005 | | | DTPA | 0.03 | 83.6195 | 8.38 | 204 | 44 | <1 | 3.5 |
| Comp.Ex. 5 | 16 | 0.15 | TMAH | 1.1 | DTPMP | 0.0005 | 0.5 | | DTPA | 0.03 | 82.2195 | 8.31 | 206 | 8.0 | <1 | 9.9 |
| Comp.Ex. 6 | 16 | 0.15 | TMAH | 1.6 | DTPMP | 0.0005 | | 1 | DTPA | 0.03 | 81.2195 | 8.29 | 179 | 32 | <1 | 2.4 |

TMAH: Tetramethylammonium hydroxide
DTPMP: Diethylenetriaminepenta(methylenephosphonic acid)
PDTMP: Propylenediaminetetra(methylenephosphonic acid)
DTPA: Diethylenetriaminepentaacetic acid
CyDTA: trans-1,2-Cyclohexanediaminetetraacetic acid monohydrate
TTHA: Triethylenetetraminehexaacetic acid
HIDA: Hydroxyethyliminodiacetic acid
HEDTA: Hydroxyethylethylenediaminetriacetic acid

Reference Signs List

1: Hard mask layer
2: Etching stop layer
3 Metal wiring

**Claims**

1. A semiconductor substrate cleaning composition comprising hydrogen peroxide, an alkaline compound, phosphoric acid and/or a salt thereof, boric acid and/or a salt thereof, aminopolymethylene phosphonic acid, and water, wherein the alkaline compound comprises at least one selected from the group consisting of quaternary ammonium hydroxide and potassium hydroxide.

2. The semiconductor substrate cleaning composition according to claim 1, wherein the salt of the phosphoric acid is at least one selected from the group consisting of quaternary ammonium phosphate salts and potassium phosphate salts, and the salt of the boric acid is at least one selected from the group consisting of quaternary ammonium borate salts and potassium borate salts.

3. The semiconductor substrate cleaning composition according to claim 1 or 2, wherein a content of the phosphoric acid and/or a salt thereof in the semiconductor substrate cleaning composition is 0.05% to 2% by mass in terms of phosphoric acid, and a content of the boric acid and/or a salt thereof in the semiconductor substrate cleaning composition is 0.1% to 4% by mass in terms of boric acid.

4. The semiconductor substrate cleaning composition according to any one of claims 1 to 3, wherein a content of the hydrogen peroxide in the semiconductor substrate cleaning composition is 10% to 30% by mass.

5. The semiconductor substrate cleaning composition according to any one of claims 1 to 4, wherein a content of the aminopolymethylene phosphonic acid in the semiconductor substrate cleaning composition is 0.00005% to 0.01% by mass.

6. The semiconductor substrate cleaning composition according to any one of claims 1 to 5, wherein a content of the quaternary ammonium hydroxide in the semiconductor substrate cleaning composition is 0.005% to 10% by mass.

7. The semiconductor substrate cleaning composition according to any one of claims 1 to 6, wherein a content of the potassium hydroxide in the semiconductor substrate cleaning composition is 0.005% to 5% by mass.

8. The semiconductor substrate cleaning composition according to any one of claims 1 to 7, wherein a pH of the semiconductor substrate cleaning composition is pH 7 to 12.

9. The semiconductor substrate cleaning composition according to any one of claims 1 to 8, wherein the quaternary ammonium hydroxide is at least one selected from the group consisting of tetramethylammonium hydroxide, tetraethylammonium hydroxide, tetrapropylammonium hydroxide, tetrabutylammonium hydroxide, and benzyltrimethylammonium hydroxide.

10. The semiconductor substrate cleaning composition according to any one of claims 1 to 9, wherein the aminopolymethylene phosphonic acid is at least one selected from the group consisting of aminotri(methylenephosphonic acid), ethylenediaminetetra(methylenephosphonic acid), diethylenetriaminepenta(methylenephosphonic acid), and 1,2-propylenediaminetetra(methylenephosphonic acid).

11. The semiconductor substrate cleaning composition according to any one of claims 1 to 10, which further comprises at least one hydrogen peroxide stabilizer selected from the group consisting of oxalic acid, diethylenetriaminepentaacetic acid, hydroxyethyliminodiacetic acid, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

12. The semiconductor substrate cleaning composition according to claim 11, wherein a content of the hydrogen peroxide stabilizer in the semiconductor substrate cleaning composition is 0.0001% to 5% by mass.

13. The semiconductor substrate cleaning composition according to any one of claims 1 to 12, which does not substantially comprise either ammonia or ammonium ions ($NH_4^+$).

14. A method for cleaning a semiconductor substrate, which comprises using the semiconductor substrate cleaning composition according to any one of claims 1 to 13 for a semiconductor substrate having an etching stop layer containing aluminum nitride, and a hard mask layer, on metal wiring containing copper and/or cobalt, so as to remove the hard mask layer.

15. The method for cleaning a semiconductor substrate according to claim 14, wherein the hard mask layer comprises at least one selected from the group consisting of titanium and titanium nitride.

16. A method for producing a semiconductor substrate, which comprises a step of using the semiconductor substrate cleaning composition according to any one of claims 1 to 13 for a semiconductor substrate having an etching stop layer containing aluminum nitride, and a hard mask layer, on metal wiring containing copper and/or cobalt, so as to remove the hard mask layer.

[Figure 1]

1

2

3

[Figure 2]

2

3

## INTERNATIONAL SEARCH REPORT

| International application No. |
|---|
| **PCT/JP2024/005151** |

| A. | CLASSIFICATION OF SUBJECT MATTER |
|---|---|

*H01L 21/304*(2006.01)i; *C11D 7/06*(2006.01)i; *C11D 7/18*(2006.01)i; *C11D 7/32*(2006.01)i; *C11D 7/36*(2006.01)i
FI: H01L21/304 647A; C11D7/32; C11D7/36; C11D7/18; C11D7/06

According to International Patent Classification (IPC) or to both national classification and IPC

| B. | FIELDS SEARCHED |
|---|---|

Minimum documentation searched (classification system followed by classification symbols)

H01L21/304; C11D7/06; C11D7/18; C11D7/32; C11D7/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2020-513440 A (ENTEGRIS, INC.) 14 May 2020 (2020-05-14)<br>paragraphs [0005]-[0071] | 1-16 |
| Y | WO 2018/061582 A1 (FUJIFILM CORPORATION) 05 April 2018 (2018-04-05)<br>paragraphs [0011]-[0156], fig. 1 | 1-16 |
| Y | WO 2018/061670 A1 (FUJIFILM CORPORATION) 05 April 2018 (2018-04-05)<br>paragraphs [0011]-[0160], fig. 1 | 1-16 |
| Y | JP 2008-285508 A (MITSUBISHI GAS CHEMICAL COMPANY, INC.) 27 November 2008<br>(2008-11-27)<br>paragraphs [0012]-[0038] | 1-16 |
| Y | WO 2022/071069 A1 (MITSUBISHI GAS CHEMICAL COMPANY, INC.) 07 April 2022<br>(2022-04-07)<br>paragraphs [0011]-[0112] | 1-16 |

☑ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **17 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**EP 4 668 318 A1**

**INTERNATIONAL SEARCH REPORT**

| International application No. |
| PCT/JP2024/005151 |

**C.    DOCUMENTS CONSIDERED TO BE RELEVANT**

| Category* | Citation of document, with indication, where appropriate, of the relevant passages | Relevant to claim No. |
|---|---|---|
| A | JP 2017-76783 A (MITSUBISHI GAS CHEMICAL COMPANY, INC.) 20 April 2017 (2017-04-20)<br>entire text, all drawings | 1-16 |
| A | JP 2017-73545 A (MITSUBISHI GAS CHEMICAL COMPANY, INC.) 13 April 2017 (2017-04-13)<br>entire text, all drawings | 1-16 |
| A | WO 2015/156171 A1 (MITSUBISHI GAS CHEMICAL COMPANY, INC.) 15 October 2015 (2015-10-15)<br>entire text, all drawings | 1-16 |
| A | WO 2022/024636 A1 (FUJIFILM CORPORATION) 03 February 2022 (2022-02-03)<br>entire text, all drawings | 1-16 |
| A | JP 2016-195251 A (AIR PRODUCTS AND CHEMICALS INC.) 17 November 2016 (2016-11-17)<br>entire text, all drawings | 1-16 |

Form PCT/ISA/210 (second sheet) (July 2022)

# EP 4 668 318 A1

| INTERNATIONAL SEARCH REPORT<br>Information on patent family members | | | International application No.<br>**PCT/JP2024/005151** | |

| Patent document<br>cited in search report | | | Publication date<br>(day/month/year) | Patent family member(s) | Publication date<br>(day/month/year) |
|---|---|---|---|---|---|
| JP | 2020-513440 | A | 14 May 2020 | US 2018/0148669 A1<br>paragraphs [0005]-[0071]<br>WO 2018/098139 A1<br>TW 201825664 A<br>KR 10-2019-0073471 A<br>CN 110023477 A | |
| WO | 2018/061582 | A1 | 05 April 2018 | US 2019/0194580 A1<br>paragraphs [0065]-[0461], fig. 1<br>KR 10-2019-0041492 A<br>TW 201819612 A | |
| WO | 2018/061670 | A1 | 05 April 2018 | US 2019/0177670 A1<br>paragraphs [0059]-[0458], fig. 1<br>KR 10-2019-0036547 A<br>TW 201819613 A | |
| JP | 2008-285508 | A | 27 November 2008 | (Family: none) | |
| WO | 2022/071069 | A1 | 07 April 2022 | US 2023/0365893 A1<br>paragraphs [0061]-[0209]<br>EP 4207250 A1<br>CN 116235282 A<br>KR 10-2023-0075433 A<br>IL 301654 A<br>TW 202225393 A | |
| JP | 2017-76783 | A | 20 April 2017 | US 2017/0110363 A1<br>CN 106601598 A<br>KR 10-2017-0044586 A<br>TW 201734192 A | |
| JP | 2017-73545 | A | 13 April 2017 | US 2017/0101607 A1<br>KR 10-2017-0042240 A<br>CN 106952803 A<br>TW 201718841 A | |
| WO | 2015/156171 | A1 | 15 October 2015 | US 2017/0183607 A1<br>EP 3093875 A1<br>KR 10-2015-0123959 A<br>CN 105210176 A<br>IL 247182 A<br>TW 201600596 A | |
| WO | 2022/024636 | A1 | 03 February 2022 | US 2023/0160072 A1<br>KR 10-2023-0033711 A<br>TW 202208608 A | |
| JP | 2016-195251 | A | 17 November 2016 | US 2016/0293479 A1<br>EP 3076424 A1<br>CN 106010826 A<br>KR 10-2016-0117361 A<br>TW 201641670 A<br>KR 10-2018-0062453 A<br>SG 10201602520U A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018098139 A
- WO 2022071069 A
- WO 2014087925 A